(19) **Europäisches Patentamt**
**European Patent Office**
**Office européen des brevets**

(11) Publication number: **0 205 148 B1**

# EUROPEAN PATENT SPECIFICATION

(45) Date of publication of patent specification: **24.04.91**

(51) Int. Cl.⁵: **G03F 7/16**

(21) Application number: **86107872.3**

(22) Date of filing: **10.06.86**

(54) Method of applying a resist.

(30) Priority: **12.06.85 JP 126133/85**

(43) Date of publication of application:
**17.12.86 Bulletin 86/51**

(45) Publication of the grant of the patent:
**24.04.91 Bulletin 91/17**

(84) Designated Contracting States:
**DE FR**

(56) References cited:
**JP-A-57 078 140**
**JP-A-59 009 919**
**JP-A-59 151 424**
**US-A- 4 500 615**

**IBM TECHNICAL DISCLOSURE BULLETIN, vol. 11, no. 8, January 1969, pages 952-953, New York, US; M.I. CURRENT et al.: "Thin-film coating"**

(73) Proprietor: **HITACHI, LTD.**
**6, Kanda Surugadai 4-chome**
**Chiyoda-ku, Tokyo 100(JP)**

(72) Inventor: **Ito, Tetsuo**
**1498-8, Kasaharacho**
**Mito-shi(JP)**
Inventor: **Tanuma, Masaya**
**299, Makadocho-2-chome**
**Naka-ku Yokohama(JP)**
Inventor: **Nakagomi, Yoshiyuki**
**2535, Nishino Shiranemachi**
**Nakakoma-gun Yamanashi-ken(JP)**
Inventor: **Kadota, Kazuya**
**2196-607, Hirai Hinodemachi**
**Nishitama-gun Tokyo(JP)**
Inventor: **Kobayashi, Kazunari**
**2196-277, Hirai Hinodemachi**
**Nishitama-gun Tokyo(JP)**

(74) Representative: **Patentanwälte Beetz sen. - Beetz jun. Timpe - Siegfried - Schmitt-Fumian**
**Steinsdorfstrasse 10**
**W-8000 München 22(DE)**

## Description

The present invention relates to a method of applying a photoresist, and particularly to a method of applying a photoresist that is adapted for a process for producing highly integrated circuit elements where little variation is allowed in the size of the developed pattern.

A method of applying a photoresist has been disclosed in Japanese Patent Laid-Open No. 155925/1984. According to this method, the photosensitive reaction is effected prior to applying the photoresist. However, nothing has been referred to in regard to optimizing the film thickness of the photoresist. Further, Japanese Patent Laid-Open Nos. 155930/1984, 155927/1984 and 155921/1984 disclose methods of applying a photoresist in relation to forming fine patterns. However, none of them teach to optimize the film thickness of the photoresist.

On the other hand, JP-A-57 78 140 discloses a photoresist applying method according to the precharacterizing part of claim 1 and describes the importance to optimise the thickness of the photoresist coated on a substrate in order to obtain a good pattern.

The object of the present invention is to provide a method of applying a resist, which is capable of increasing the production yields of highly integrated circuit elements while decreasing the variance in the developing size of elements formed on the silicon wafers.

Said object is achieved, according to the present invention, by a photoresist applying method comprising a process for spin-coating a substrate with a photoresist, a process for transferring a mask pattern onto the coated photoresist film followed by exposure, and a developing process for forming a pattern on the substrate after the photoresist has been exposed, wherein the spin-coating process comprises the steps of:

(a) determining a plurality of extreme values of a curve in which the width of the developed pattern of said photoresist pulsates sinusoidally in relation to the increase or decrease of a photoresist thickness , and

(b) controlling said spin-coating by setting a parameter variable in response to the thickness of the photo-resist to a value that corresponds with one of said extreme values of said pulsation to minimize variations in the width of the developed pattern as caused by variations in said parameter.

Preferably said parameter is the number of spinner revolutions applied to said substrate in forming the photoresist thereon.

If a photoresist film is applied too thickly, little light enters into the interior of the photoresist film and the size changes after developing. This is called the bulk effect. With a contracted projection exposure apparatus which uses light of a single wavelength, however, the reflectance varies on the surface of the resist due to interference of light in the photoresist film. Therefore, interference in which uses are develops the size of the developed pattern pulsates sinusoidally as the film thickness increases. In such a case, variance in the size of the developed pattern can be minimized by setting the thickness of the photoresist film to a value that corresponds to an extreme value (a portion where the gradient of a curve that represents the dependency the developed size of the upon the thickness of photoresist film becomes zero) of pulsation.

Fig. 1 is a diagram which shows the dependency of the developing size of the photoresist upon the thickness of the photoresist film according to an embodiment of the present invention;

Fig. 2 is a section view of the photoresist;

Fig. 3 is a diagram which illustrates the projection of mask pattern onto the photoresist;

Fig. 4 is a diagram of distribution to explain the variance in the developing size; and

Fig. 5 is a diagram which shows the dependency of the developing size of the photoresist upon the number of revolutions of the spinner.

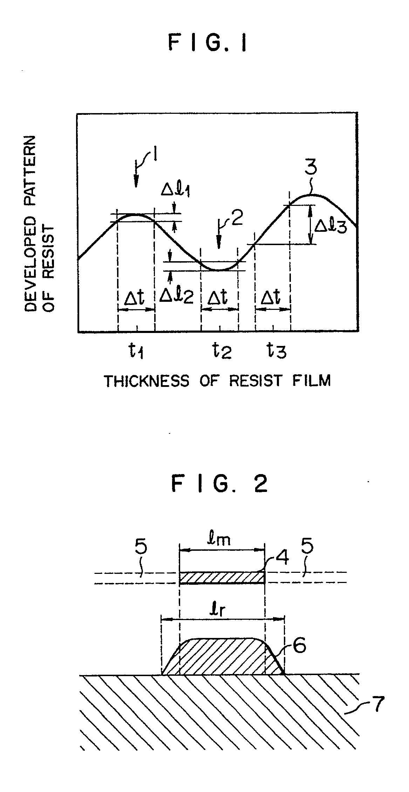

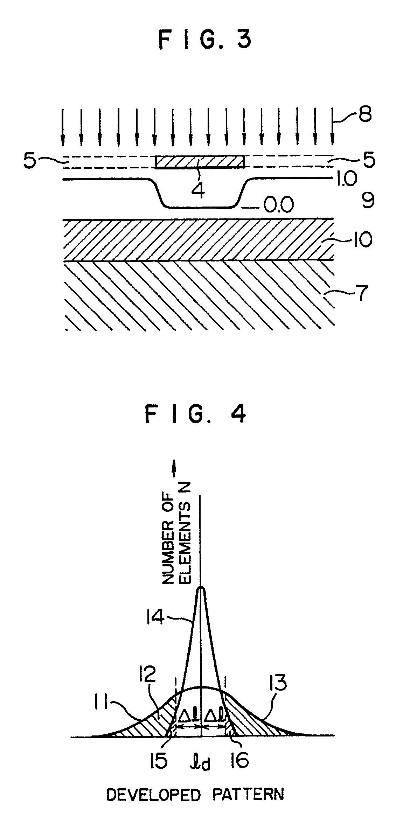

An embodiment of the invention will be described below in conjunction with Fig. 1. It was found that as the thickness of the photoresist film is increased by about 10 nm each time, the resist size (width $\ell r$ of resist line 6 of Fig. 2, which should desirably be equal to the line width $\ell m$ of a mask pattern which consists of a line portion 4 and a space portion 5) after developing pulsates as represented by a curve 3 in Fig. 1. A process for forming the resist line 6 on a silicon substrate 7 will be described below in conjunction with Fig. 3. First, the silicon substate 7 is spin-coated with a photoresist 10 to a thickness of about 1 $\mu$m. A projected image of mask pattern consisting of space portion and line portion is then irradiated with a source of ultraviolet rays. In this case, the intensity of light on the photoresist 10 is weak at a position which corresponds to the line portion and is strong at a position which corresponds to the space portion, as represented by a curve 9. If developing is performed after irradiation with ultraviolet rays, the photoresist melts at a portion which corresponds to the strongly irradiated space portion 5. The photoresist at a portion corresponding to the weakly irradiated line portion 4 does not melt but remains to form the resist line 6 shown in Fig. 2.

This is a positive type of photoresist. In the case of a negative-type photoresist, on the other hand, a resist line is formed at a portion that corresponds to the space portion.

When a silicon wafer is spin-coated with the photoresist to a thickness of about 1 $\mu$m, in general, the film thickness does not become uniform but varies by about 20 nm (200 angstroms). Therefore, variance develops in the width of resist line that is formed after developing. As is evident from Fig. 1, the range of variance of the line width greatly changes depending upon the set point (central value in the variance of resist film thickness) of the thickness of photoresist film. For instance, if the thickness of the photoresist film is denoted by $t_3$, the film thickness varies over a range $\Delta t$; consequently, the developed pattern varies over a range $\Delta \ell_3$. However, if the thickness of the photoresist film is set to $t_2$ which corresponds to a minimum value of the curve 3, the developed pattern varies over a range $\Delta \ell_2$ despite the thickness of the photoresist film varing over the same range $\Delta t$, which is a reduction into about one-fifth from the range $\Delta \ell_3$. Even if the thickness of the photoresist film is set to $t_1$ which corresponds to a maximum value 1 of the curve 3, the developing size varies over a range $\Delta \ell_1$, which is a reduction into about one-fifth from the range $\Delta \ell_3$. Here, the range $\Delta \ell_3$ generally has a value of 0.3 $\mu$m. This value becomes intolerable as the resist size approaches 1 $\mu$m.

Here, it is presumed that the allowable value of variance in the developing size is $\pm \Delta \ell$ with respect to the design size $\ell d$ in the photoresist process for producing semiconductor elements. If now the setpoint of thickness of the photoresist film is erroneously set to $t_3$ in Fig. 1, the size of the developed pattern greatly, and the number of semiconductor elements relative to the developed pattern is distributed as represented by a curve 11. Many elements (those denoted by 12, 13) that lie outside the allowable pattern $\ell d \pm \Delta \ell$ become defective. However, when the setpoint of the thickness of the photoresist film is set to $t_1$ or $t_2$ in Fig. 1, variance in the developed pattern decreases as represented by a curve 14, and the proportion of defective elements decreases to less than 10% as distributed in the portions denoted by 15 and 16.

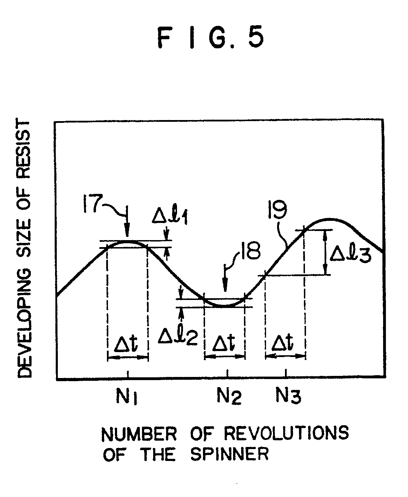

In the foregoing were mentioned the pulsation of the resist developed pattern relative to the thickness of the photoresist film and the accompanying variance. When the thickness of the photoresist film cannot be directly measured, however, the developed pattern of the photoresist is measured relative to the number of revolutions of the spinner (spin-coating apparatus) which applies the resist to a thickness of about 1 $\mu$m. The thickness of photoresist film pulsates as represented by a curve 17 in Fig. 5. As the number of revolutions of the spinner is changed as denoted by $N_1$, $N_2$ and $N_3$, the developed pattern varies little as denoted by $\Delta \ell_1$ and $\Delta \ell_2$ when the number of revolutions $N_1$, $N_2$ correspond to extreme values 17, 18 even though the thickness of the photoresist film varies over the same range $\Delta t$ as that of Fig. 1. When the number of revolutions $N_3$ does not correspond to the extreme value, however, the developed pattern varies over an increased range $\Delta \ell_3$. Thus, by suitably setting the number of revolutions of the spinner, variance in the developed pattern can be reduced.

Fig. 4 is a diagram which illustrates the variance in the developing size.

## Claims

1. A photoresist applying method comprising a process for spin-coating a substrate (7) with a photoresist (10), a process for transferring a mask pattern (4, 5) onto the coated photoresist film followed by exposure (8), and a developing process for forming a pattern on the substrate (7) after the photoresist (10) has been exposed, wherein the spin-coating process comprises the steps of:

   (a) determining a plurality of extreme values of a curve in which the width of the developed pattern of said photoresist (10) pulsates sinusoidally in relation to the increase or decrease of a photoresist thickness , and
   (b) controlling said spin-coating by setting a parameter variable in response to the thickness of the photo-resist (10) to a value that corresponds with one of said extreme values of said pulsation to minimize variations in the width of the developed pattern (4, 5) as caused by variations in said parameter.

2. A photoresist applying method according to claim 1, wherein said parameter is the number of spinner revolutions applied to said substrate (7) in forming the photoresist (10) thereon.

## Revendications

1. Procédé pour appliquer une résine photosensible, comprenant une opération d'enduction en rotation d'un substrat (7) avec une résine photosensible (10), une opération de transfert d'un motif de masque (4,5) sur la pellicule de résine photosensible déposée, suivi par une exposition (8), et une opération de développement servant à former un motif sur le substrat (7) après l'exposition de la résine photosensible (10), l'opération d'enduction en rotation comprenant les étapes consistant à:

   (a) déterminer une pluralité de valeurs extrêmes d'une courbe, suivant laquelle la largeur du motif développé de ladite résine photosensible (10) varie d'une manière pulsatoire sinusoïdale en liaison avec l'accroissement ou la réduction de l'épaisseur de la résine photosensible, et

(b) commander ladite enduction en rotation au moyen du réglage d'un paramètre variable en réponse à l'épaisseur de la résine photosensible (10), sur une valeur qui correspond à l'une desdites valeurs extrêmes de ladite pulsation afin de réduire au minimum les variations de la largeur du motif développé (4,5), provoquées par des variations dudit paramètre.

2. Procédé pour appliquer une résine photosensible selon la revendication 1, selon lequel ledit paramètre est le nombre de rotations du dispositif rotatif appliquées audit substrat (7) lors de la formation de la résine photosensible (10) sur ce substrat.

**Ansprüche**

1. Verfahren zum Auftragen eines Photoschutzlacks, das ein Verfahren zur Spin-Beschichtung eines Substrats (7) mit einem Photoschutzlack (10), ein Verfahren zur Übertragung eines Abdeckmusters (4, 5) auf den beschichteten Photoschutzlack, gefolgt von Belichtung (8), und ein Entwicklungsverfahren zur Bildung eines Musters auf dem Substrat (7), nach der Belichtung des Photoschutzlacks (10), umfaßt, wobei das Verfahren der Spin-Beschichtung die Schritte:

(a) Bestimmung mehrerer Extremwerte einer Kurve, in der die Breite des entwickelten Musters des Photoschutzlacks (10) sinusförmig in Abhängigkeit zum Anstieg oder Abfall der Dicke des Photoschutzlacks pulsiert, und

(b) Regelung der Spin-Beschichtung durch Festsetzen eines im Ansprechen auf die Dicke des Photoschutzlacks (10) variablen Parameters auf einen Wert umfaßt, der einem der Extremwerte des Pulsierens entspricht, um Veränderungen der Breite des entwickelten Musters (4, 5) zu minimieren, wie sie durch Veränderungen des Parameters verursacht werden.

2. Verfahren zum Auftragen eines Photoschutzlacks nach Anspruch 1, wobei der Parameter die Anzahl der Umdrehungen des Spinners ist, die bei der Bildung des Photoschutzlacks (10) auf das Substrat (7) angewendet werden.

## F I G. I

## F I G. 2

# F I G. 3

# F I G. 4

NUMBER OF ELEMENTS N

DEVELOPED PATTERN

# F I G. 5

NUMBER OF REVOLUTIONS
OF THE SPINNER